# EUROPEAN PATENT SPECIFICATION

(11) **EP 3 557 560 B1**
(45) Date of publication and mention of the grant of the patent: **16.07.2025**
(21) Application number: 19170017.8
(22) Date of filing: 18.04.2019
(51) Int. Cl.: G09B 19/24

(54) **SIMULATED WELDING TRAINING SUPPORTING REAL-WORLD APPLICATIONS**
SIMULIERTES SCHWEISSTRAININGS ZUR UNTERSTÜTZUNG VON ANWENDUNGEN IN DER REALEN WELT
FORMATION DE SOUDAGE SIMULÉE PRENANT EN CHARGE DES APPLICATIONS DU MONDE RÉEL

(30) Priority: 19.04.2018 US 201862659729 P; 27.03.2019 US 201916366300
(43) Date of publication of application: 23.10.2019
(73) Proprietor: Lincoln Global, Inc., Santa Fe Springs, CA 90670 (US)
(72) Inventor: MEESS, Brian, Cleveland, OH Ohio 44102 (US); Matthews, William Thomas, Chesterland, OH Ohio 44026 (US); Scales, Jason A., Perry, OH Ohio 44081 (US)
(74) Representative: Grosse Schumacher Knauer von Hirschhausen

(56) References cited:
- WO-A1-2014/140721
- US-A1- 2011 062 132
- US-A1- 2012 029 674
- US-A1- 2013 189 658

## Description

### FIELD OF THE INVENTION

The invention is related to a welding simulator according to claim 1 and to a welding training system according to claim 11. The present application is being filed as a non-provisional patent application claiming priority from, and any other benefit of, U.S. Provisional Patent Application No. 62/659,729 filed on April 19, 2018. T

The present invention pertains to systems for training welders using a simulated (e.g., virtual or augmented reality) welding environment, and more particularly to training welders to weld complex assemblies using a simulated welding environment, thus eliminating the need for an actual assembly on which to train.

### TECHNICAL BACKGROUND

Until recently, welding was taught in a real-world setting, that is to say that welding was taught by using an actual welding gun and sample workpieces of metal that were positioned to mimic a weld joint that was the type of which the welding student intended to learn. Instructors would guide the student during the process of making a weld. The student would learn to weld the particular weld joint that was simulated by the sample workpieces. This process required safety equipment, a suitable work environment, and consumed materials such as welding rod/wire, workpieces, and the electrical power consumed by the welding machine. Additionally, because of the arc and other dangers involved in actual welds, instructors and other students were susceptible to injury from welding flash, sparks, and burns from hot workpieces. Students learned by instruction and repetition, requiring potentially large numbers of sample workpieces and consumed materials. In more recent times, systems have been employed that simulate welding training.

Welding training and welding simulation are known in the art. Examples and further details regarding these concepts are found in the following commonly-assigned U.S. patents and patent applications :
(1) U.S. patent 8,747,116, filed on July 10, 2009, issued on June 10, 2015, and entitled System And Method Providing Arc Welding Training In A Real-Time Simulated Virtual Reality Environment Using Real-Time Weld Puddle Feedback;
(2) U.S. patent 8,915,740, filed on July 10, 2009, issued on December 23, 2014, and entitled Virtual Reality Pipe Welding Simulator;
(3) U.S. patent 9,483,959, filed on July 17, 2009, issued on November 1, 2016, and entitled Welding Simulator;
(4) U.S. patent 8,657,605, filed on April 7, 2011, issued on February 25, 2014, and entitled Virtual Testing And Inspection Of A Virtual Weldment;
(5) U.S. patent 9,011,154, filed on February 2, 2012, issued on April 21, 2015, and entitled Virtual Welding System;
(6) U.S. patent 8,911,237, filed on July 10, 2012, issued on December 16, 2014, and entitled Virtual Reality Pipe Welding Simulator And Setup;
(7) U.S. patent application 14/132,496, filed on December 18, 2013, and entitled Weld Sequence Editor.
US2013189658 discloses a virtual reality arc welding system that provides virtual reality simulations for training purposes.

These systems incorporate motion and position sensors that receive the position and motion of a mock welding tool (gun) and a simulated electrode carried by that tool. Example systems might incorporate the use of virtual reality to simulate a student's manipulation of a mock electrode and sample workpieces in a virtual (e.g., computer generated) environment. The systems track position and orientation of the mock electrode and sample workpieces. These conventional systems enable the student to learn how to manipulate the welding tool (developing muscle memory) but do not provide realistic education when the sample workpieces are assembled into a structure, particularly when the structure involves a larger number of pieces, require welds performed in a particular order, or comprise welds that require the user to approach the welds from a variety of angles as would be the case were a student welding an actual structure. Because the pieces used in a structure may not be standard shapes that are easily obtained for training, a system for and method of generating these shapes is required. Additionally, a system and method is required that facilitates training the student to perform welding on either simulated or actual complex structures. Welding complex structures is often performed with robotic welding machinery however, these robots must be programmed to perform these complex welds. A system and method for recording movement instructions provided by a user where that user is provided with guidance as the user performs a simulated or actual weld for which the user's movements are recorded for use by the robot welder.

### DESCRIPTION

In order to overcome the aforementioned disadvantages and/or to improve welding training aspects, a welding simulator of claim 1 is described and a welding training system according to claims 7 and 12. Preferred embodiments are subject of the subclaims. An exemplary embodiment of a welding simulator comprises a display, a mock welding tool; a plurality of coupons representing a plurality of simulated workpieces; a database which comprises assembly position and orientation data for the plurality of simulated workpieces arranged into a simulated structure; and a housing holding logic comprising a memory storing machine-readable instructions and a processor for executing the instructions to generate a simulated environment in which the plurality of simulated workpieces are arranged according to the position and orientation data; define a plurality of weld paths for a training exercise, wherein the weld paths are defined by the arrangement of the simulated workpieces; track a plurality of traversals of the mock welding tool corresponding to the plurality of weld paths; and display the simulated environment, a plurality of simulated welds resulting from the plurality of traversals, and the simulated structure formed by the simulated plurality of simulated welds combined with the arrangement of the simulated workpieces.

In another exemplary embodiment, the processor executes instructions to calculate a parameter of each of the plurality of simulated welds.

In another exemplary embodiment, the processor executes instructions to display an indication of the calculated parameter of each of the plurality of simulated welds.

In another exemplary embodiment, the processor executes instructions to calculate a score for the structure determined from an aggregate of the calculated parameter of each of the plurality of simulated welds.

In another exemplary embodiment, the processor executes instructions to apply a simulated force to the simulated structure, determine a simulated stress present at each of the plurality of simulated welds, and determine if the calculated parameter of each of the plurality of welds is sufficient to withstand the simulated stress present at each of the respective plurality of welds.

In another exemplary embodiment, the processor executes instructions to display in the simulated environment, an indication of the likelihood of failure of the structure.

An exemplary embodiment of a welding training system comprises a display configured to project images into the field of view of a user, a welding tool, a workpiece, a housing holding logic comprising a memory storing machine-readable instructions and a processor for executing the instructions to define a weld path using the workpiece, select an area of the weld path, generate a graphic that provides information regarding the selected area to the user; and display the graphic over the selected area in the user's field of view.

In another exemplary embodiment of a welding training system, the graphic that provides information regarding the selected area to the user suggests an action to be taken by the user in the selected area.

In another exemplary embodiment of a welding training system, a score is generated that represents the quality of the simulated weld. In some exemplary embodiments, the score is displayed on the display.

In another exemplary embodiment of a welding training system, the processor executes instructions to track a traversal of the welding tool relative to the weld path, and display the weld resulting from the traversal overlaid on a portion of the workpiece in the user's field of view.

In another exemplary embodiment of a welding training system, the information regarding the selected area comprises virtual cues, images, and other information for aiding the user in performing the operation.

An exemplary embodiment of a welding training system comprises a display, a welding tool, a housing holding logic comprising a memory storing machine-readable instructions and a processor for executing the instructions to generate a simulated environment in which a weld path for a weld is defined, track a first traversal of the welding tool relative to the weld path, display the simulated environment and a weld resulting from the first traversal, store data that defines characteristics of the first traversal, and transfer the data to a robotic welding system for execution by the robot welding system of a second traversal which is based on the first traversal.

In another exemplary embodiment of a welding training system, the characteristics of the first traversal comprise at least one of a list comprising: tip of the tool to workpiece distance, angle of the tool, and travel speed of the tool.

In another exemplary embodiment of a welding training system, the weld resulting from the first traversal is a simulated weld.

In another exemplary embodiment of a welding training system, the weld resulting from the first traversal is an actual weld.

An exemplary embodiment of a welding training system comprises a display, a welding tool, a housing holding logic comprising a memory storing machine-readable instructions and a processor for executing the instructions to generate a simulated environment in which a weld path for a weld is defined, track a first traversal of the welding tool relative to the weld path, display the simulated environment and a weld resulting from the first traversal, store data that defines characteristics of the first traversal; and transfer the data to a robotic welding system for execution by the robot welding system of a second traversal which is based on the first traversal.

In another exemplary embodiment of a welding training system, the characteristics of the first traversal comprise at least one of: a distance between a tool tip and the workpiece, angle of the tool, and travel speed of the tool.

### BRIEF DESCRIPTION OF THE DRAWINGS

These and other features of the general inventive concept will become better understood with regard to the following description and accompanying drawings in which:
FIG. 1 is a diagram of a welding simulator configured for use by a single user according to an exemplary embodiment;
FIGS. 2a-2c are perspective views of an example assembly used as a model for a simulated assembly according to an exemplary embodiment;
FIG. 3 is a diagram illustrating a two-dimensional view of simulated components and a representation of a data file used by an exemplary embodiment to represent those components;
FIG. 4 is a diagram illustrating a grid of wexels according to an exemplary embodiment;
FIGS. 5a-5c are perspective views of an assembly formed from the simulated components of FIG. 3;
FIG. 6 is a side view of a face mounted display device according to an exemplary embodiment;
FIG. 7 is a rear perspective view of a welding helmet that incorporates the face mounted display device of FIG. 6 according to an exemplary embodiment;
FIG. 8 is a representative user view of a simulated welding environment displayed by the face mounted display device of FIG. 6 in an exemplary embodiment;
FIG. 9 is a diagram illustrating a simulated force applied to a simulated assembly according to an exemplary embodiment;
FIG. 10 is diagram illustrating a simulated force applied to a simulated assembly to the point of simulated failure of the simulated assembly according to an exemplary embodiment;
FIG. 11 is a representative user view of an assembly and welding gun with a simulated weld being generated and overlaid onto the user view by the face mounted display device of FIG. 6 in an exemplary embodiment;
FIG. 12 is a representative user view of the assembly and welding gun of FIG. 11 with instructional feedback overlaid onto the user view by the face mounted display device of FIG. 6 in an exemplary embodiment;
FIG. 13 is a perspective view of an assembly with a simulated welding gun and weld superimposed on the assembly so that movement data can be captured according to an exemplary embodiment; and
FIG. 14 is a view of a robotic welder receiving the data gathered from the operation illustrated in FIG. 13 in order to perform an actual weld on an assembly according to an exemplary embodiment.

### DETAILED DESCRIPTION

An exemplary embodiment of a welding simulator comprises a processor-based subsystem, a spatial tracker operatively connected to the processor-based subsystem, at least one mock welding tool capable of being spatially tracked by the spatial tracker, and at least one display device operatively connected to the programmable processor-based subsystem. The welding simulator is capable of simulating, in a virtual reality space, operations associated with a real-world welding station. In an exemplary embodiment, these operations can include various different types of welds and non-welding operations. Generally, the virtual reality welding station may include any or all of the features and capabilities disclosed in the patents and patent applications.

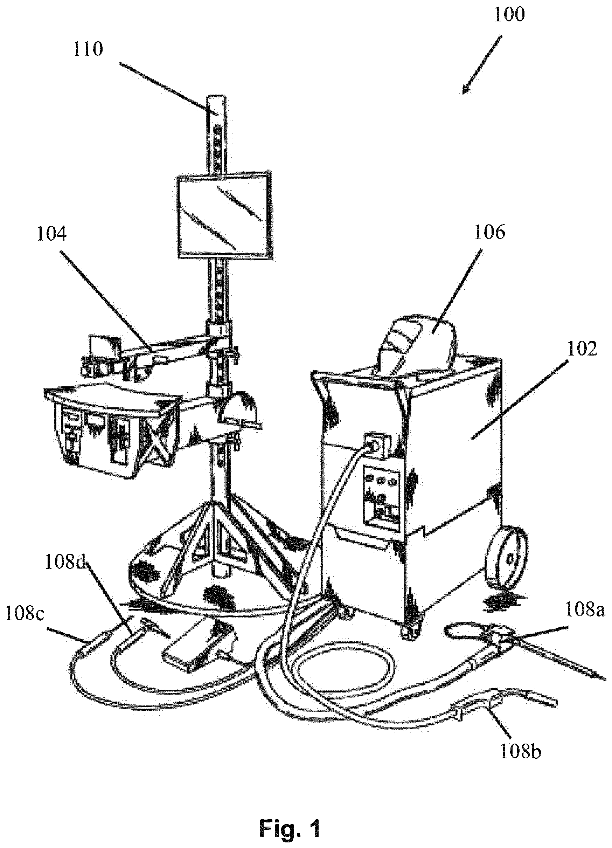

FIG. 1 illustrates a system block diagram of a welding simulator 100 for providing welding training in a real-time simulated reality environment according to an exemplary embodiment. The welding simulator 100 includes a programmable processor-based subsystem (PPS) 102. The welding simulator 100 further includes a 3-D spatial tracker 104 operatively connected to the programmable processor-based subsystem 102. In the illustrated embodiment, the 3-D spatial tracker 104 is embedded in an arm of a table/stand 110. However, because complex assemblies may not be capable of mounting on a table/stand 110, in other exemplary embodiments, the 3-D spatial tracker 104 may be located in a stand or other device that can be positioned in or near a complex assembly. The welding simulator 100 also includes a face-mounted display device 106 operatively connected to the programmable processor-based subsystem 102 and the 3-D spatial tracker 104. The welding simulator 100 also includes at least one mock welding tool 108(a)-108(d) operatively connected to the 3-D spatial tracker 104 and the programmable processor-based subsystem 102. As illustrated, certain exemplary embodiments of the welding simulator 100 may include a table/stand 110. As is described in greater detail in the patents and patent applications, the 3-D spatial tracker 104 provides the location and orientation of a mock welding tool 108(a)-108(d), the face-mounted display device 106, and a coupon located at the table/stand 110. With this information, the programmable processor-based subsystem 102 generates a simulated environment that comprises a simulated workpiece (or workpieces) represented by the coupon (or coupons), and a simulated welding tool represented by the mock welding tool 108(a)-108(d). The position and orientation of the face-mounted display device 106 is used to determine the view that should be presented to the user who is wearing the face-mounted display device 106. For example, if the user is looking at one of the mock welding tools 108(a)-108(d), a simulated welding tool should be positioned in the display such that the user is presented with an image that represents the user's view of the mock welding tool as it would appear if the user was looking at an actual welding tool in the real world. The same applies to the workpiece or workpieces, such that the user is presented with a believable simulated welding environment to enhance the user's learning experience.

In complex structures, a user may be required to perform the welding operation in a distinct manner or sequence. For instance, if a portion of a structure is inaccessible once the structure is assembled, any welding operations to that portion must be done before a point in the assembly of the structure at which the portion becomes inaccessible. In relatively simple structures, it may be easy for a user to determine which weld portions must be performed first. However, in more complex structures or those structures in which earlier welds may result in an impact to later welds, a weld sequencer may be employed. A weld sequencer for use in a simulated welding environment is described in application number 14/132,496, filed December 18, 2013.

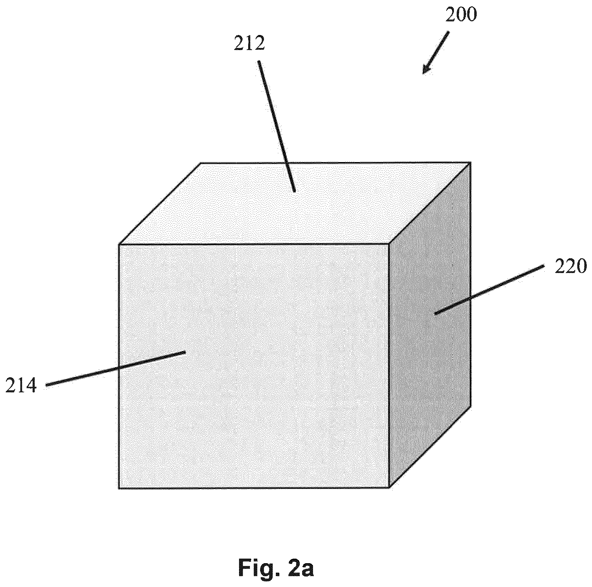

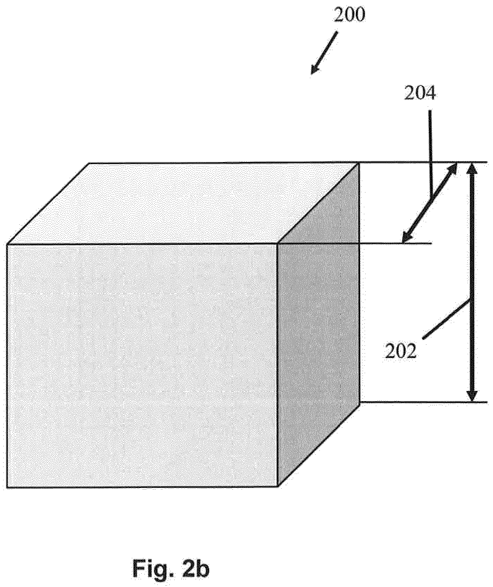

Actual welding environments would likely include a plurality of workpieces and those workpieces would often be more complex than simple rectangular plates. However, in order to facilitate the reader's understanding of the concepts presented herein, a cube-shape structure will be used to represent a complex structure in order to further describe the exemplary embodiments presented herein. An example of such a cube-shaped structure 200 is shown in FIG. 2a. In order to develop models of the various components that are used to form the cube-shaped structure 200, information that describes those components must be received or captured by a welding simulator 100. Because many components are now designed and produced using computer-aided design (CAD) models, an exemplary embodiment of the system 100 may develop a three-dimensional model of each component of the cube-shaped structure 200 using information obtained from such a CAD model. As illustrated by the simplified model in FIG. 2b, a CAD model may comprise a height 202 and depth 204 measurement of a component. In addition, the CAD model may also comprise, without limitation, thickness, various information related to curvatures, and other component characteristics. The CAD model may provide information regarding the material from which the component is to be fabricated. This information is of particular interest in simulated welding as it is used for example, to establish the behavioral characteristics of a simulated workpieces when subjected to a simulated weld. It could also be used when rendering the simulated workpieces in the simulated environment.

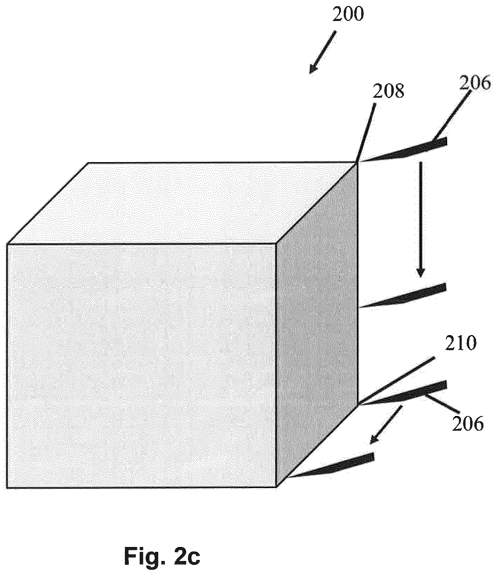

In certain circumstances, a CAD model may not be available, or the component may have been modified from its original design for one reason or another. In such cases, an exemplary embodiment may construct a model by measurement of an actual part. This approach is illustrated in FIG. 2(c). As shown, a measurement tool 206 is moved from a first location to a second location (preferably a corner or other such location that is used to define the boundaries of the component). As shown, the measurement tool 206 moves from a first point 208 toward a second point 210. When the second point is reached, the distance from the first point 208 to the second point 210 is measured and entered into a component model. As shown, other component dimensions are measured to arrive at a computer model that accurately describes the component characteristics. As was described for FIG. 2b, the material from which the component is fabricated may also be stored in the computer model.

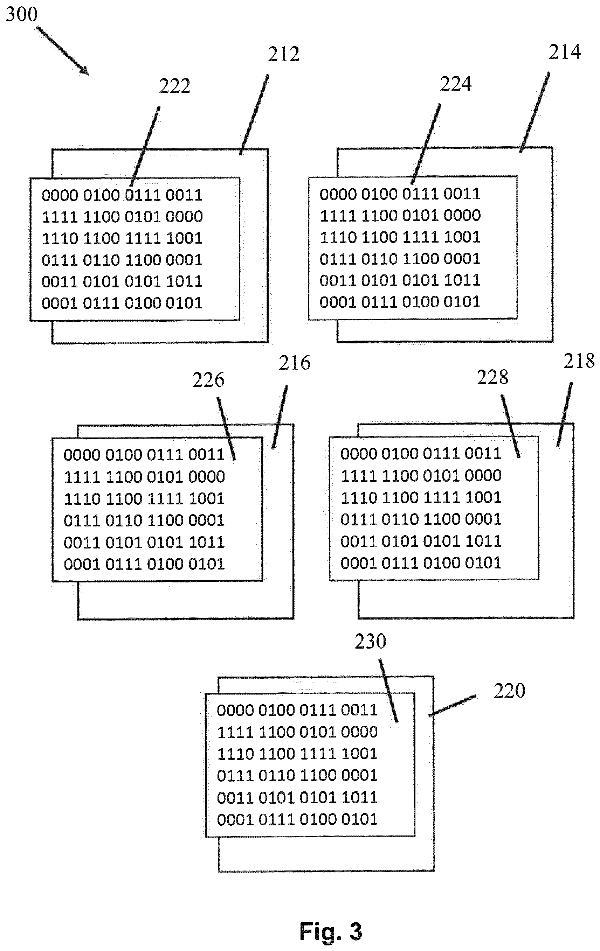

Referring back to the cube 200 of FIG. 2a, an example cube structure is formed from a top 212, a front 214, a back 216 (not shown), a left side 218 (not shown), and a right side 220. In this example, there is no bottom side used. Using the CAD model of FIG. 2B, or the direct measurement method of FIG. 2c, component models 300 represented by digital data are created. An example of such models 300 is shown in FIG. 3. Shown is a top 212 model represented by digital data 222, a front 214 model represented by digital data 224, a back 216 model represented by digital data 226, a left side 218 model represented by digital data 228, and a right side 220 model represented by digital data 230.

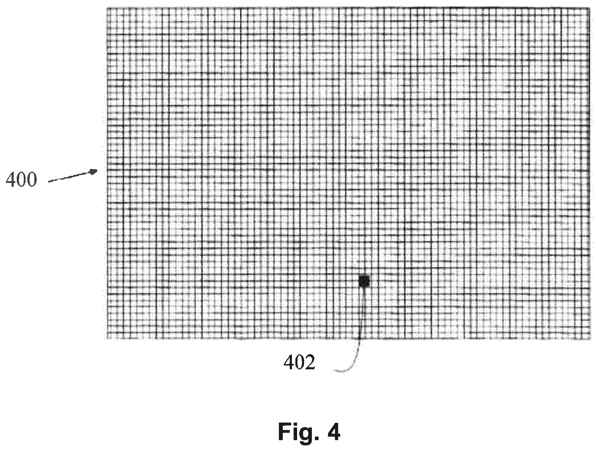

In order to simulate the reaction of a component model 300 to simulated welding operation, the models are constructed from a number of elements referred to as wexels. An example of this is shown in FIG. 4 which illustrates a wexel map 400 made up of a number of wexels 402. This concept is described in greater detail in U.S. Patent 8,911,237 referenced above. In an actual simulation, the number of wexels 402 in a component model 300 would be significantly greater than that shown in FIG. 4. Each wexel 402 comprises data characterizing a portion of a component where such data may comprise information used to determine, without limitation, melting temperature and characteristics, thermal conductivity, electrical conductivity, and oxidation characteristics. Each wexel 402 may also comprise information related to the current state of the portion of a component. An example, without limitation, may be the predicted temperature of the component at the location represented by the wexel 402.

The system 100 is capable of simulating a weld puddle having real-time molten metal fluidity and heat dissipation characteristics. The welding simulator 100 is capable of modeling how simulated welding activity affects the weld joint, e.g., the underlying base material. Illustratively, the welding simulator 100 may emulate welding a root pass and a hot pass, as well as subsequent fill and cap passes, each with characteristics paralleling real-world scenarios. Each subsequent pass may weld significantly different from that of the previous pass as a result of changes in the base material made during the previous pass and/or as a result of a differently selected electrode. Real-time feedback of the puddle modeling allows the user to observe the simulated welding process on the face-mounted display device 106 and adjust or maintain his or her technique as the simulated weld is being performed. Examples of the kinds of simulated indicators observed may include: flow of the weld puddle, shimmer of molten puddle, changes in color during puddle solidification, freeze rate of the puddle, color gradients of heat dissipation, sound, bead formation, weave pattern, formation of slag, undercut, porosity, spatter, slag entrapment, overfill, blow-through, and occlusions to name a few. It is to be realized that the puddle characteristics are dependent upon, that is to say responsive to, the user's movement of a mock welding tool 108(a)-108(d). In this manner, the displayed weld puddle is representative of a real-world weld puddle formed in real-time based on the selected welding process and on the user's welding technique. In an exemplary embodiment, the number of wexels 402 representing the surface of a simulated workpiece is fixed. Therefore, once an initial puddle is generated in virtual reality space during a simulated welding process using the welding simulator 100, the number of wexels 402 plus puddle particles tends to remain relatively constant. This is because the number of wexels 402 that are being processed is fixed and the number of puddle particles that exist and are being processed during the welding process tend to remain relatively constant because puddle particles are being created and "destroyed" at a similar rate (i.e., the puddle particles are temporary).

In accordance with an alternate embodiment of the present invention, puddle particles may be generated within or below the surface of the simulated workpiece. In such an embodiment, displacement may be modeled as being positive or negative with respect to the original surface displacement of a virgin (i.e., un-welded) simulated workpiece. In this manner, puddle particles may not only build up on the surface of a simulated workpiece, but may also penetrate the simulated workpiece. However, the number of wexels 402 is still fixed and the puddle particles being created and destroyed is still relatively constant.

In accordance with alternate embodiments of the present invention, instead of modeling particles, a wexel displacement map may be provided having more channels to model the fluidity of the puddle. Or, instead of modeling particles, a dense voxel map may be modeled. Or, instead of a wexel displacement map (e.g., the wexel map 400), only particles may be modeled which are sampled and never go away. Such alternative embodiments may not provide a relatively constant processing load for the system (e.g., the PPS 102), however.

Furthermore, in accordance with an embodiment of the present invention, blow-through or a keyhole is simulated by taking material away. For example, if a user keeps an arc in the same location for too long, in the real world, the material would bum away causing a hole. Such real-world burnthrough is simulated in the welding simulator 100 by wexel decimation techniques. If the amount of heat absorbed by a wexel 402 is determined to be too high by the welding simulator 100, that wexel 402 may be flagged or designated as being burned away and rendered as such (e.g., rendered as a hole). Subsequently, however, wexel re-constitution may occur for certain welding process (e.g., pipe welding) where material is added back after being initially burned away. In general, the welding simulator 100 simulates wexel decimation (taking material away) and wexel reconstitution (adding material back). In addition to the non-visible "puddle" particles described herein, the welding simulator 100 also uses three other types of visible particles to represent Arc, Flame, and Spark effects, in accordance with an embodiment of the present invention. These types of particles do not interact with other particles of any type but interact only with the displacement map. While these particles do collide with the simulated weld surface, they do not interact with each other. Only puddle particles interact with each other, in accordance with an embodiment of the present invention. The physics of the Spark particles is setup such that the Spark particles bounce around and are rendered as glowing dots in virtual reality space.

The physics of the Arc particles is setup such that the Arc particles hit the surface of the simulated workpiece or weld bead and stay for a while. The Arc particles are rendered as larger dim bluish-white spots in virtual reality space. It takes many such spots superimposed to form any sort of visual image. The end result is a white glowing nimbus with blue edges.

The physics of the Flame particles is modeled to slowly raise upward. The Flame particles are rendered as medium sized dim red-yellow spots. It takes many such spots superimposed to form any sort of visual image. The end result is blobs of orange-red flames with red edges raising upward and fading out. Other types of non-puddle particles may be implemented in the welding simulator 100, in accordance with other embodiments of the present invention. For example, Smoke particles may be modeled and simulated in a similar manner to Flame particles.

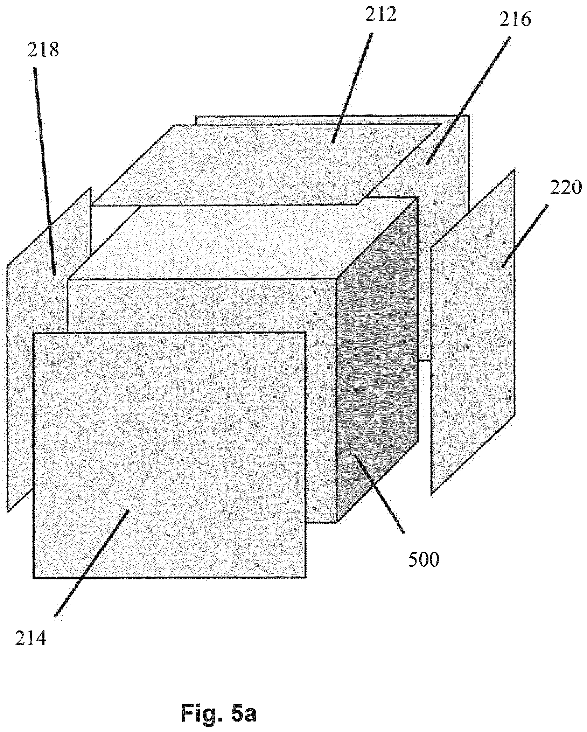

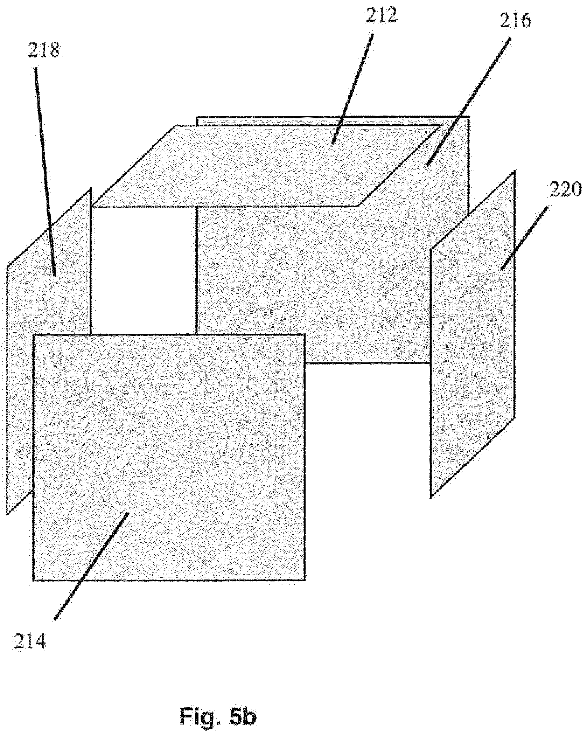

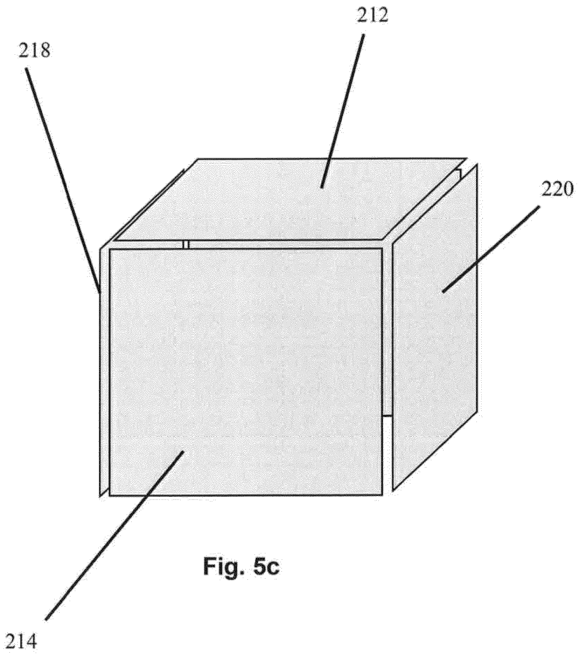

FIG. 5a illustrates a completed structure 500 as well as those components forming the structure 500 (i.e., a top 212, a front 214, a back 216, a left side 218, and a right side 220 component). In an exemplary embodiment, an image such as FIG. 5a may be presented to a user in order to provide guidance with regard to the final location of the various components used to form the structure 500. FIG. 5b represents the top 212, the front 214, the back 216, the left side 218, and the right side 220 components as they may be positioned prior to assembly of the structure 500. In an exemplary embodiment, a user may be instructed to move the components into place such that a welding operation can be performed to create the structure. This is illustrated in FIG. 5c where the top 212, the front 214, the back 216, the left side 218, and the right side 220 are shown nearly in position such that they can be welded together by a user.

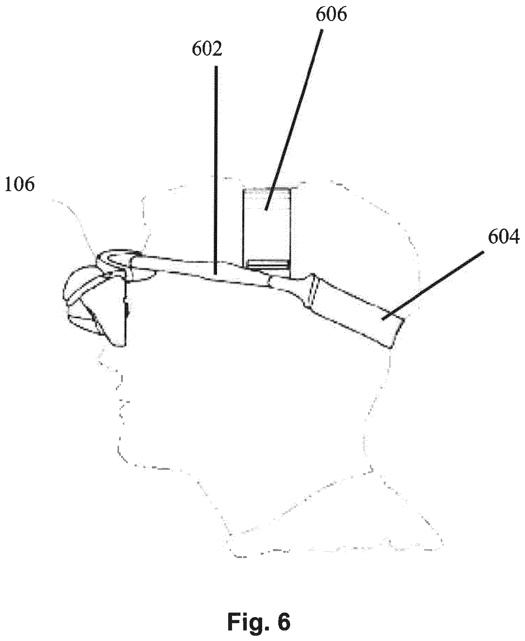

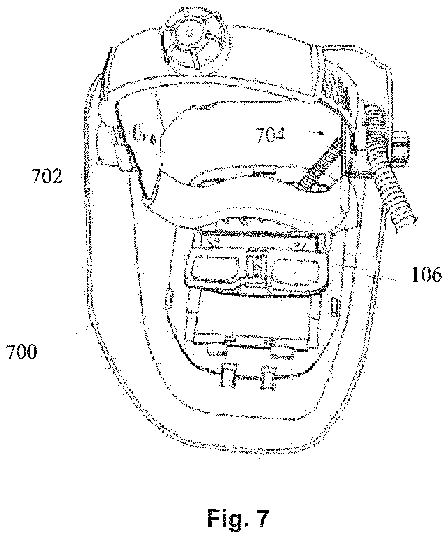

In an exemplary embodiment, the face-mounted display device 106 is positioned such the display is positioned in front of a user's eyes as illustrated in FIG. 6. As shown, the face-mounted display device 106 may be secured in position by earpieces 602 and a rear 604 and top 606 strap. This arrangement ensures that the face-mounted display device 106 remains in position as the user moves his or her head. Because the described embodiment simulates a welding operation, the face-mounted display device 106 may be located inside a welding helmet 700 as shown in FIG. 7. In addition to the face-mounted display device 106, the welding helmet 700 also comprises a position sensor receiver 702 that is in communication with the PPS 102 (not illustrated in FIG. 7) using a communication cable 704 or other method of communicating information between the welding helmet 700 and the programmable processor-based subsystem 102. As was described earlier herein, the image from the face-mounted display device 106 may represent the simulated welding environment that is presented to the user. The welding helmet 700 could also included one or more speakers to present simulated welding sounds.

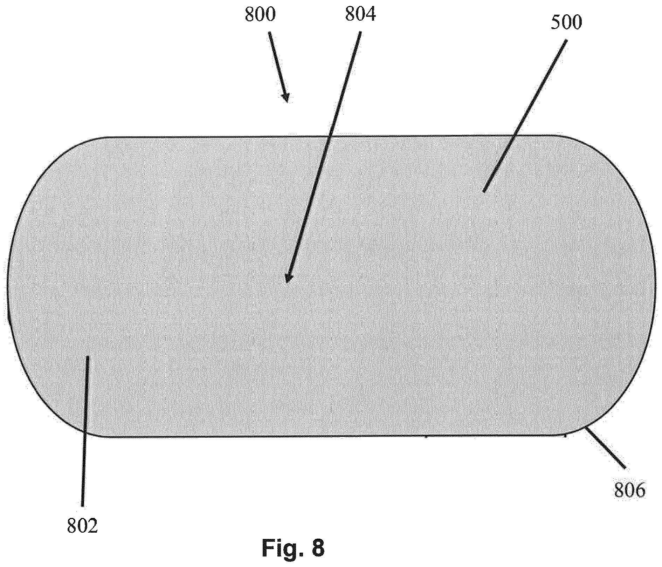

FIG. 8 illustrates an image of the simulated welding environment 800 presented to a user. The structure 500 is displayed. Also illustrated is a simulated welding gun 802 and the simulated weld 804 being created by the welding gun 802. Because this is a simulated environment displayed by the face-mounted display device 106, there is no real-world workpiece that would be visible to a user outside of the face-mounted display device 106. Because the face-mounted display device 106 is located in the welding helmet 700, as the user moves his or her head to change a field of view 806 that would be located in a direction that the user is looking, the image displayed in the face-mounted display device 106 will also change to represent that portion of the simulated welding environment that corresponds with the user's field of view 806.

In order to facilitate learning, learning systems such as the welding simulator 100 may be configured to provide a score or grade of a user's work in order to both rank the user according to his or her peers and also in order to encourage the user to try harder in order to achieve and maintain a more desirable score. In existing welding simulators, a score or rating is derived from data stored by wexels 402 that represent very small portions of the weld and surrounding metals. Scores generated by simulators may represent a predicted strength of a weld, an appearance of the weld, and the efficiency of the user performing the weld. For example, a low-efficiency user may have to repair defects or otherwise go back over his or her work, resulting in a higher level of time spent inspecting for and correcting errors whereas a higher efficiency user may be able to perform the weld with minimal or no defects, resulting in a lower level of time spent.

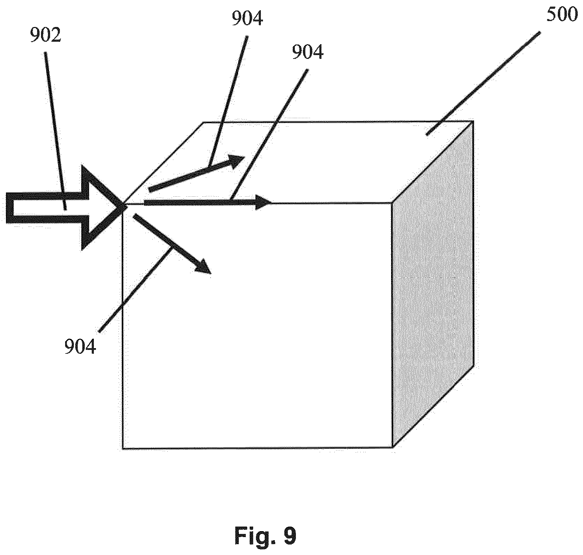

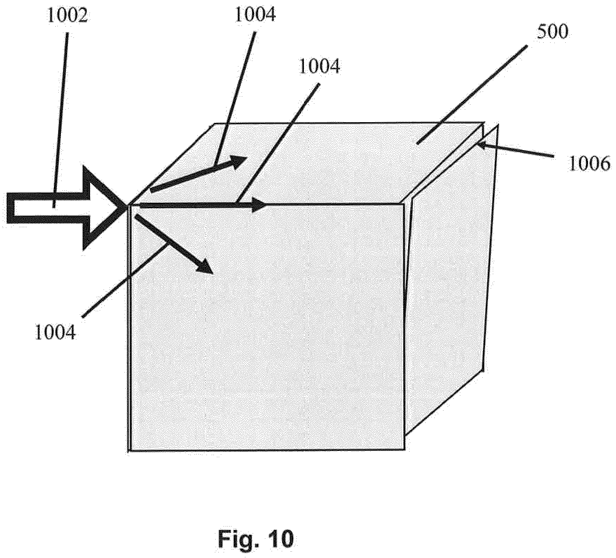

The welding simulator 100 is capable of analyzing and displaying the results of simulated weld station activity. By analyzing the results, it is meant that the welding simulator 100 is capable of determining when during the specified process steps, including welding and non-welding operations, the user deviated from the acceptable limits of the specified processes. As noted above, a score may be used to quantify the user's performance. In exemplary embodiments, the score may be a function of missed operations; improperly fixtured parts; deviation in position, orientation, and speed of the mock welding tool through ranges of tolerances, which may extend from an ideal welding pass to marginal or unacceptable welding activity; missed quality checks; or any other operations associated with the selected weld station. In an exemplary embodiment, a user may be performing an exercise involving fabricating complex structures such as the structure 500. Rather than (or in addition to) scoring the user on each individual weld as described previously, an exemplary embodiment may perform simulated testing on the completed simulated structure. An example structure 500 is illustrated in FIG. 9. In simulated testing, a force 902 is applied to a portion (e.g., a corner) of the structure 500. This force is distributed across the structure 500 as shown by the force vectors 904. These vectors serve to simulate the effects of an actual force on a structure 500. A quality score for the structure 500 is calculated using a calculated strength for each individual weld of the structure 500 and the force that is exerted on each such weld. In an exemplary embodiment, a certain simulated force is applied to the structure 500. If the structure 500 does not experience a simulated failure, a score is calculated. In such an exemplary embodiment, the score may be "pass" or "fail." In another exemplary embodiment, a certain force is applied to the structure 500. A resultant simulated force is calculated at each weld of the structure 500. A score may be derived for each weld based on a calculated percentage of strength remaining in the weld as the certain force is applied. The scores of all welds in the structure are summed to arrive at a final score. In another exemplary embodiment, an example of which is illustrated in FIG. 10, a simulated force 1002 is applied to the structure 500. The force is distributed across the structure 500 as illustrated by the force vectors 1004 until the force at each weld results in a failure of one or more welds 1006. The amount of force required to reach failure is compared to an established level of force and a score is calculated. This score may be used to establish a user ranking, determine if a minimum level of performance has been reached, or otherwise provide feedback to a user to enable them to gauge their progress as they perform various training exercises.

Up to this point, the described exemplary embodiments have been directed to training exercises in which a simulated environment is generated that includes simulated workpieces used to perform simulated welds. As was described earlier herein, such a system enables a user to practice welds repeatedly without consuming actual materials.

In another exemplary embodiment of a welding simulator, instead of a simulated workpiece, an actual workpiece may be used. Such an embodiment may allow a user to practice a simulated weld on an actual structure before performing a real weld. This may be useful when the structure is especially valuable or the quality of the resulting weld is extremely critical. For example, bridges, ships, submarines, and aircraft.

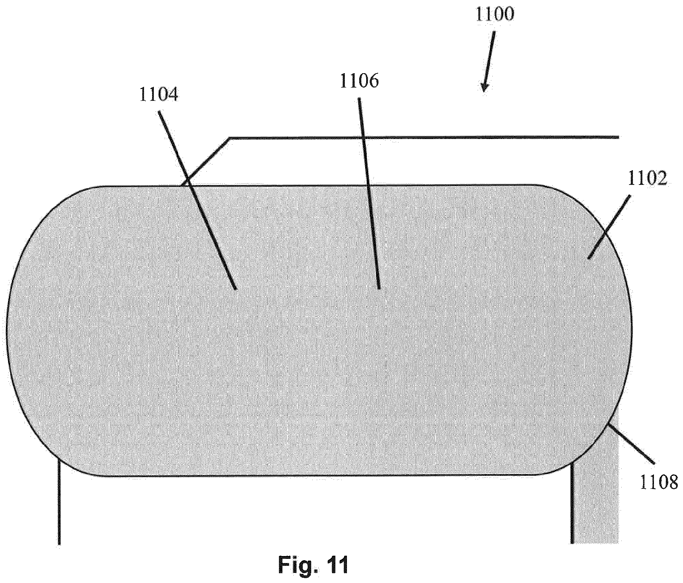

A cube shaped structure 1100 is shown in FIG. 11. Unlike the exemplary embodiments described thus far, this cube shaped structure 1100 is an actual physical structure rather than a simulated structure. In such an exemplary embodiment, the user views the actual workpieces comprising the structure 100 as he or she performs a simulated weld. Thus, the face-mounted display device 106 in such embodiments is configured to project images into a user's field of view 1108 without blocking the user's view of actual objects. As shown, the user may view the actual welding gun 1104 and simulated images of a welding operation 1106 superimposed on the cube shaped structure 1100. This superimposition allows a user to perform a weld in a simulated environment (e.g., virtually or using augmented reality) without damaging potentially valuable workpieces. In such embodiments, a score may be derived for this simulated weld as described elsewhere herein. The score may be presented to a user to enable that user to continue practicing until a desired or minimum score is reliably achieved. Once a user has demonstrated a satisfactory level of proficiency, the user may perform the actual weld with the welding tool 1104. Thus, an exemplary embodiment allows a user to refine their technique with regard to a particular weld without damage to the workpiece or consumption of welding materials. The determination of a score provides a level of feedback to a user and allows the user to focus their improvement efforts on a particular aspect of the weld if necessary to achieve a desired result.

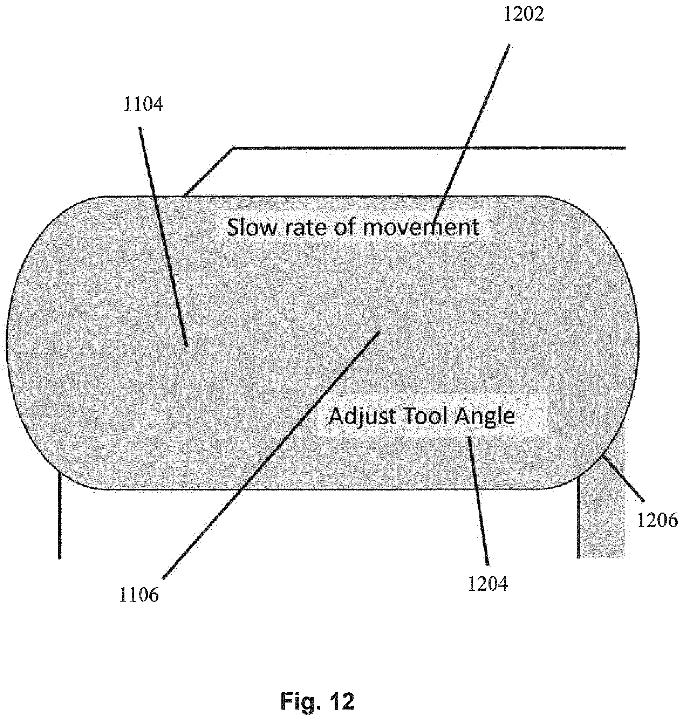

To further enhance a user's efforts to achieve an optimal weld on a structure, guidance or other information may be superimposed over an actual workpiece. This is illustrated in FIG. 12. As shown, a welding gun 1104 is illustrated as producing simulated images of a welding operation 1106. Alternatively, this welding operation could be an actual welding operation. Guidance to the user 1202 and 1204 is superimposed in a user's field of view 1206 by the face-mounted display device 106. This exemplary embodiment thus provides continuous feedback to a user in actual or simulated welding operations. This feedback can provide enhanced training to a user or alternatively, may provide guidance to a user during an actual weld if it is determined that the user is in need of correction to produce an optimal weld.

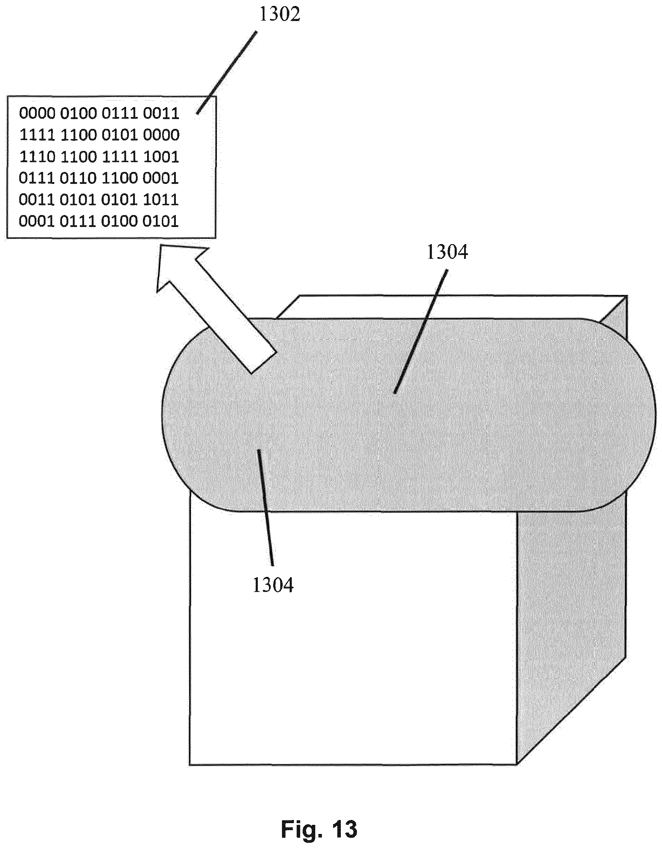

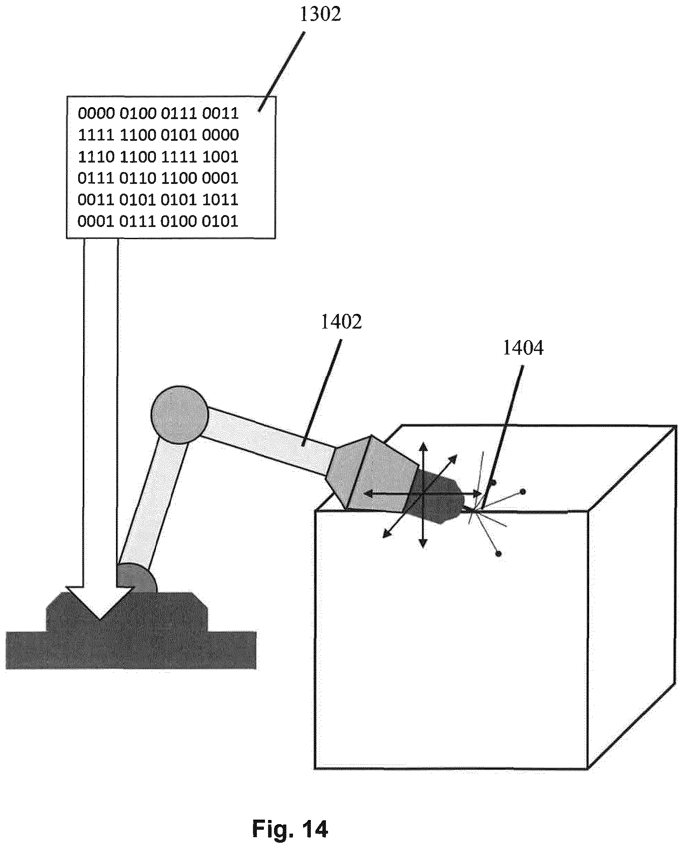

Training robotic welding systems by having a human user move a welding gun, real or simulated, along an area to which a weld is applied is known; however, these systems generally rely on the human user performing the weld in an optimal manner. Exemplary embodiments provide a simulated environment in which a human user can perform the simulated weld while receiving feedback as described herein. The feedback can be in the form of a score or grade after a simulated weld is complete. In such an exemplary embodiment, illustrated in FIG. 13, a user can store data 1302, such as welding gun movement data, as a simulated weld 1304 is completed. Once the user is satisfied with the simulated weld, the data 1302 can be provided to a robot 1402 in order to duplicate the simulated weld 1304 with an actual weld 1404 as illustrated in FIG. 14.

In summary, disclosed is a system and method of a simulated reality welding system that supports real-world welding training. The system is capable of simulating, in a simulated reality space, a plurality of components that are arranged into a predetermined orientation and welded together using a simulated welding process to create a virtualized structure that represents an assembly comprised from the plurality of components. The invention has been described herein with reference to the disclosed embodiments. Obviously, modifications and alterations will occur to others upon a reading and understanding of this specification. It is intended to include all such modifications and alterations insofar as they come within the scope of the appended claims or the equivalence thereof.

**REFERENCE NUMBERS**

| | | | |
|---|---|---|---|
| 100 | welding simulator | 230 | digital data |
| 102 | programmable processor-based subsystem | 300 | component model |
| | | 400 | wexel map |
| 104 | 3-D spatial tracker | 402 | wexel |
| 106 | face-mounted display device | 500 | completed structure |
| 108a | mock welding tool | 602 | ear piece |
| 108b | mock welding tool | 604 | rear strap |
| 108c | mock welding tool | 606 | top strap |
| 108d | mock welding tool | 700 | welding helmet |
| 110 | table | 702 | sensor receiver |
| 200 | cube-shaped structure | 704 | communication cable |
| 202 | height measurement | 800 | welding environment |
| 204 | depth measurement | 802 | welding gun |
| 206 | measurement tool | 806 | field of view |
| 208 | first point | 902 | force |
| 210 | second point | 904 | force vector |
| 212 | top | 1002 | simulated force |
| 214 | front | 1004 | force vector |
| 216 | back | 1006 | weld |
| 218 | left side | 1100 | cube-shaped structure |
| 220 | right side | 1104 | welding gun |
| 222 | digital data | 1106 | welding operation |
| 224 | digital data | 1108 | field of view |
| 226 | digital data | 1202 | user |
| 228 | digital data | 1204 | user |
| 1206 | field of view | 1402 | robot |
| 1302 | data | 1404 | weld |
| 1304 | simulated weld | | |

## Claims

1. A welding simulator (100) comprising:
a display (106);
a welding tool (108a, 108b, 108c, 108d);
a plurality of coupons representing a plurality of simulated workpieces;
assembly position and orientation data for the plurality of simulated workpieces arranged into a simulated structure; and
a housing holding logic comprising a memory storing machine-readable instructions and a processor for executing the instructions:
**characterized in that** the welding tool is a mock welding tool, and **in that** the processor is arranged for executing the instructions to:
generate a simulated virtual or augmented environment in which the plurality of simulated workpieces are arranged according to the position and orientation data;
define a plurality of weld paths for a training exercise, wherein the weld paths are defined by the arrangement of the simulated workpieces;
track a plurality of traversals of the mock welding tool (108a, 108b, 108c, 108d) corresponding to the plurality of weld paths; and
display the simulated virtual or augmented environment, a plurality of simulated welds resulting from the plurality of traversals, and the simulated structure formed by the simulated plurality of simulated welds combined with the arrangement of the simulated workpieces.

2. The welding simulator (100) of claim 1, wherein the processor executes instructions to calculate a parameter of each of the simulated welds.

3. The welding simulator (100) of claim 1 or 2, wherein the processor executes instructions to display an indication of the calculated parameter of each of the simulated welds, and/or wherein the processor executes instructions to calculate a score for the structure determined from an aggregate of the calculated parameter of the simulated welds, and/or wherein the processor executes instructions to:
apply a simulated force to the simulated structure;
determine a simulated stress present at each of the plurality of simulated welds; and
determine if each of the simulated welds is sufficient to withstand the simulated stress applied thereto.

4. The welding simulator (100) of any of the claims 1 to 3, wherein the simulated workpieces represent portions of an assembly, and/or wherein the simulated workpieces are stored as computer-aided design models.

5. The welding simulator (100) of any of the claims 1 to 4, wherein each of the simulated workpieces is stored as a plurality of measurements taken from an actual part.

6. The welding simulator (100) of any of the claims 1 to 5, wherein the display is configured to allow a real-world object to be viewed in a user's field of vision.

7. A welding simulator according to any of the claims 1 to 6,
**characterized in that** the processor is arranged for executing instructions to:
generate a simulated virtual or augmented environment in which the plurality of simulated workpieces are arranged according to the position and orientation data and a weld path for a weld is defined by the arrangement of the simulated workpieces;
track a plurality of traversals of the mock welding tool corresponding to the plurality of weld paths;
display the simulated virtual or augmented environment, and an actual weld resulting from the plurality of simulated welds resulting from the plurality of traversals, and the simulated structure; and
store data that defines characteristics of the plurality of traversals.

8. The welding simulator of claim 7, wherein the processor executes instructions to transfer the stored data to a robotic welding system for execution by the robot welding system.

9. The welding simulator of claim 7 or 8, where the characteristics of the plurality of traversals comprise at least one of: a distance from the tip of the tool to the workpiece, an angle of the tool, and a travel speed of the tool.

10. The welding simulator of any of the claims 7 to 9, where the welds resulting from the plurality of traversals are simulated welds, and/or where the welds resulting from the plurality of traversals are actual welds.

11. A welding training system according to any of the claims 1 to 10, further comprising:
the display (106) configured to project images into the field of view of a user (1202, 1204); wherein the processor is arranged to:
define a weld path using the plurality of workpieces;
select an area of the weld path;
generate a graphic that provides information regarding the area to the user (1202, 1204); and
display the graphic in a manner that overlays the graphic within the area in the user's field of view.

12. The welding training system of claim 11, wherein the graphic comprises a suggested action to be taken by the user (1202, 1204).

13. The welding training system of claim 11 or 12, wherein the processor executes instructions to:
track a traversal of the welding tool relative to the weld path; and
display a simulated weld resulting from the traversal in the user's field of view, and/or
wherein the processor executes instructions to:
track a traversal of the welding tool relative to the weld path; and
display an actual weld resulting from the traversal overlaid on a portion of the workpiece in the user's field of view.

14. The welding training system of any of the claims 11 to 13, wherein a score is generated that represents the quality of a simulated weld.

15. The welding training system of any of the claims 11 to 14, wherein the information regarding the selected area comprises one or more virtual cues, images, and other information for grading the user (1202, 1204) in performing an operation.

## Patentansprüche

1. Schweißsimulator (100), umfassend:
eine Anzeige (106);
ein Schweißwerkzeug (108a, 108b, 108c, 108d);
mehrere Schweißstücke, die mehrere simulierte Werkstücke darstellen;
Montagepositions- und -ausrichtungsdaten für die mehreren simulierten Werkstücke, die zu einer simulierten Struktur angeordnet sind; und
ein Gehäuse, in dem Logik untergebracht ist, die einen Speicher, der maschinenlesbare Instruktionen speichert, und einen Prozessor zum Ausführen der Instruktionen umfasst;
**dadurch gekennzeichnet, dass** das Schweißwerkzeug eine Schweißwerkzeugattrappe ist, und dass der Prozessor dafür ausgelegt ist, die Instruktionen auszuführen zum:
Generieren einer simulierten virtuellen oder erweiterten Umgebung, in der die mehreren simulierten Werkstücke gemäß den Positions- und Ausrichtungsdaten angeordnet sind;
Definieren mehrerer Schweißpfade für eine Schulungsübung, wobei die Schweißpfade durch die Anordnung der simulierten Werkstücke definiert sind;
Verfolgen mehrerer Schweißbewegungen der Schweißwerkzeugattrappe (108a, 108b, 108c, 108d) entsprechend den mehreren Schweißpfaden; und
Anzeigen der simulierten virtuellen oder erweiterten Umgebung, mehrerer simulierter Schweißnähte, die aus den mehreren Schweißbewegungen resultieren, und der simulierten Struktur, die durch die simulierten mehreren simulierten Schweißnähte in Kombination mit der Anordnung der simulierten Werkstücke gebildet wurde.

2. Schweißsimulator (100) nach Anspruch 1, wobei der Prozessor Instruktionen zum Berechnen eines Parameters jeder der simulierten Schweißnähte ausführt.

3. Schweißsimulator (100) nach Anspruch 1 oder 2, wobei der Prozessor Instruktionen ausführt, um eine Angabe des berechneten Parameters jeder der simulierten Schweißnähte anzuzeigen, und/oder wobei der Prozessor Instruktionen ausführt, um eine Wertung für die Struktur zu berechnen, die aus einer Gesamtheit des berechneten Parameters der simulierten Schweißnähte bestimmt wird, und/oder wobei der Prozessor Instruktionen ausführt zum:
Anlegen einer simulierten Kraft an die simulierte Struktur;
Bestimmen einer simulierten Belastung, die an jeder der mehreren simulierten Schweißnähte vorhanden ist; und
Bestimmen, ob jede der simulierten Schweißnähte hinreichend ist, um der an sie angelegten simulierten Belastung zu widerstehen.

4. Schweißsimulator (100) nach einem der Ansprüche 1 bis 3, wobei die simulierten Werkstücke Abschnitte einer Baugruppe darstellen, und/oder wobei die simulierten Werkstücke als mittels Computer-Aided Design erzeugte Modelle gespeichert sind.

5. Schweißsimulator (100) nach einem der Ansprüche 1 bis 4, wobei jedes der simulierten Werkstücke als mehrere Messungen gespeichert ist, die an einem realen Teil vorgenommen wurden.

6. Schweißsimulator (100) nach einem der Ansprüche 1 bis 5, wobei die Anzeige dazu eingerichtet ist, das Betrachten eines realen Objekts im Sichtfeld eines Benutzers zu erlauben.

7. Schweißsimulator nach einem der Ansprüche 1 bis 6,
**dadurch gekennzeichnet, dass** der Prozessor dafür ausgelegt ist, Instruktionen auszuführen zum:
Generieren einer simulierten virtuellen oder erweiterten Umgebung, in der die mehreren simulierten Werkstücke gemäß den Positions- und Ausrichtungsdaten angeordnet sind und ein Schweißpfad für eine Schweißnaht durch die Anordnung der simulierten Werkstücke definiert ist;
Verfolgen mehrerer Schweißbewegungen der Schweißwerkzeugattrappe entsprechend den mehreren Schweißpfaden;
Anzeigen der simulierten virtuellen oder erweiterten Umgebung und einer tatsächlichen Schweißnaht, die aus den mehreren simulierten Schweißnähten resultiert, die aus den mehreren Schweißbewegungen resultieren, und der simulierten Struktur; und
Speichern von Daten, die Eigenschaften der mehreren Schweißbewegungen definieren.

8. Schweißsimulator nach Anspruch 7, wobei der Prozessor Instruktionen ausführt, um die gespeicherten Daten an ein Roboterschweißsystem zum Ausführen durch das Roboterschweißsystem zu übertragen.

9. Schweißsimulator nach Anspruch 7 oder 8, wobei die Eigenschaften der mehreren Schweißbewegungen mindestens eines von Folgendem umfassen: eine Distanz von der Spitze des Werkzeugs zu dem Werkstück, einen Winkel des Werkzeugs, und eine Vorschubgeschwindigkeit des Werkzeugs.

10. Schweißsimulator nach einem der Ansprüche 7 bis 9, wobei die Schweißnähte, die aus den mehreren Schweißbewegungen resultieren, simulierte Schweißnähte sind, und/oder wobei die Schweißnähte, die aus den mehreren Schweißbewegungen resultieren, tatsächliche Schweißnähte sind.

11. Schweißschulungssystem nach einem der Ansprüche 1 bis 10, des Weiteren umfassend:
die Anzeige (106), die dazu eingerichtet ist, Bilder in das Sichtfeld eines Benutzers (1202, 1204) zu projizieren; wobei der Prozessor ausgelegt ist zum:
Definieren eines Schweißpfades unter Verwendung der mehreren Werkstücke;
Auswählen eines Bereichs des Schweißpfades;
Generieren einer Grafik, die dem Benutzer (1202, 1204) Informationen bezüglich des Bereichs vermittelt; und
Anzeigen der Grafik in einer solchen Weise, dass die Grafik über den Bereich im Sichtfeld des Benutzers gelegt ist.

12. Schweißschulungssystem nach Anspruch 11, wobei die Grafik eine vorgeschlagene Aktion umfasst, die durch den Benutzer (1202, 1204) ausgeführt werden soll.

13. Schweißschulungssystem nach Anspruch 11 oder 12, wobei der Prozessor Instruktionen ausführt zum:
Verfolgen einer Schweißbewegung des Schweißwerkzeugs relativ zu dem Schweißpfad; und
Anzeigen einer simulierten Schweißnaht, die aus der Schweißbewegung resultiert, im Sichtfeld des Benutzers, und/oder
wobei der Prozessor Instruktionen ausführt zum:
Verfolgen einer Schweißbewegung des Schweißwerkzeugs relativ zu dem Schweißpfad; und
Anzeigen einer tatsächlichen Schweißnaht, die aus der Schweißbewegung resultiert, die über einen Abschnitt des Werkstücks gelegt ist, im Sichtfeld des Benutzers.

14. Schweißschulungssystem nach einem der Ansprüche 11 bis 13, wobei eine Wertung generiert wird, die die Qualität einer simulierten Schweißnaht darstellt.

15. Schweißschulungssystem nach einem der Ansprüche 11 bis 14, wobei die Informationen bezüglich des ausgewählten Bereichs einen oder mehrere virtuelle Hinweise, Bilder und andere Informationen zum Benoten des Benutzers (1202, 1204) bei der Durchführung einer Operation umfassen.

## Revendications

1. Simulateur de soudage (100) comprenant :
un dispositif d'affichage (106) ;
un outil de soudage (108a, 108b, 108c, 108d) ;
une pluralité de coupons représentant une pluralité de pièces d'ouvrage simulées ;
des données de position et d'orientation d'assemblage pour la pluralité de pièces d'ouvrage simulées agencées dans une structure simulée ; et
un boîtier contenant une logique comprenant une mémoire stockant des instructions lisibles par machine et un processeur pour exécuter les instructions,
**caractérisé en ce que** l'outil de soudage est un outil de soudage de simulation, et **en ce que** le processeur est agencé pour exécuter les instructions pour :
générer un environnement augmenté ou virtuel simulé dans lequel la pluralité de pièces d'ouvrage simulées sont agencées en fonction des données de position et d'orientation ;
définir une pluralité de trajets de soudage pour un exercice de formation, dans lequel les trajets de soudage sont définis par l'agencement des pièces d'ouvrage simulées ;
suivre une pluralité de traversées de l'outil de soudage de simulation (108a, 108b, 108c, 108d) correspondant à la pluralité de trajets de soudage ; et
afficher l'environnement augmenté ou virtuel simulé, une pluralité de soudures simulées découlant de la pluralité de traversées, et la structure simulée constituée par la pluralité simulée de soudures simulées combinées avec l'agencement des pièces d'ouvrage simulées.

2. Simulateur de soudage (100) selon la revendication 1, dans lequel le processeur exécute des instructions pour calculer un paramètre de chacune des soudures simulées.

3. Simulateur de soudage (100) selon la revendication 1 ou 2, dans lequel le processeur exécute des instructions pour afficher une indication du paramètre calculé de chacune des soudures simulées, et/ou dans lequel le processeur exécute des instructions pour calculer un score pour la structure, déterminé à partir d'un cumul du paramètre calculé des soudures simulées, et/ou dans lequel le processus exécute des instructions pour :
appliquer une force simulée à la structure simulée ;
déterminer une contrainte simulée présente au niveau de chacune de la pluralité de soudures simulées ; et
déterminer si chacune des soudures simulées est ou non suffisante pour résister à la contrainte simulée qui lui est appliquée.

4. Simulateur de soudage (100) selon l'une quelconque des revendications 1 à 3, dans lequel les pièces d'ouvrage simulées représentent des parties d'un assemblage, et/ou dans lequel les pièces d'ouvrage simulées sont stockées sous forme de modèles de conception assistée par ordinateur.

5. Simulateur de soudage (100) selon l'une quelconque des revendications 1 à 4, dans lequel chacune des pièces d'ouvrage simulées est stockée sous forme d'une pluralité de mesures prises à partir d'une pièce réelle.

6. Simulateur de soudage (100) selon l'une quelconque des revendications 1 à 5, dans lequel le dispositif d'affichage est configuré pour permettre la visualisation d'un objet du monde réel dans un champ de vision d'un utilisateur.

7. Simulateur de soudage selon l'une quelconque des revendications 1 à 6,
**caractérisé en ce que** le processeur est agencé pour exécuter des instructions pour :
générer un environnement augmenté ou virtuel simulé dans lequel la pluralité de pièces d'ouvrage simulées sont agencées en fonction des données de position et d'orientation et un trajet de soudage pour une soudure est défini par l'agencement des pièces d'ouvrage simulées ;
suivre une pluralité de traversées de l'outil de soudage de simulation correspondant à la pluralité de trajets de soudage ;
afficher l'environnement augmenté ou virtuel simulé, et une soudure réelle découlant de la pluralité de soudures simulées découlant de la pluralité de traversées, et la structure simulée ; et
stocker des données qui définissent des caractéristiques de la pluralité de traversées.

8. Simulateur de soudage selon la revendication 7, dans lequel le processeur exécute des instructions pour transférer les données stockées à un système de soudage robotique pour leur exécution par le système de soudage robotique.

9. Simulateur de soudage selon la revendication 7 ou 8, dans lequel les caractéristiques de la pluralité de traversées comprennent au moins l'un parmi : une distance depuis la pointe de l'outil jusqu'à la pièce d'ouvrage, un angle de l'outil, et une vitesse de déplacement de l'outil.

10. Simulateur de soudage selon l'une quelconque des revendications 7 à 9, dans lequel les soudures découlant de la pluralité de traversées sont des soudures simulées, et/ou dans lequel les soudures découlant de la pluralité de traversées sont des soudures réelles.

11. Système de formation de soudage selon l'une quelconque des revendications 1 à 10, comprenant en outre :
le dispositif d'affichage (106) configuré pour projeter des images dans le champ de vision d'un utilisateur (1202, 1204) ; dans lequel le processeur est agencé pour :
définir un trajet de soudage à l'aide de la pluralité de pièces d'ouvrage ;
sélectionner une zone du trajet de soudage ;
générer un graphique qui fournit des informations relatives à la zone à l'utilisateur (1202, 1204) ; et afficher le graphique d'une manière qui superpose le graphique à l'intérieur de la zone dans le champ de vision de l'utilisateur.

12. Système de formation de soudage selon la revendication 11, dans lequel le graphique comprend une action suggérée qui doit être prise par l'utilisateur (1202, 1204).

13. Système de formation de soudage selon la revendication 11 ou 12, dans lequel le processeur exécute des instructions pour :
suivre une traversée de l'outil de soudage par rapport au trajet de soudage ; et
afficher une soudure simulée découlant de la traversée dans le champ de vision de l'utilisateur, et/ou
dans lequel le processeur exécute des instructions pour :
suivre une traversée de l'outil de soudage par rapport au trajet de soudage ; et
afficher une soudure réelle découlant de la traversée superposée sur une partie de la pièce d'ouvrage dans le champ de vision de l'utilisateur.

14. Système de formation de soudage selon l'une quelconque des revendications 11 à 13, dans lequel un score est généré qui représente la qualité d'une soudure simulée.

15. Système de formation de soudage selon l'une quelconque des revendications 11 à 14, dans lequel les informations relatives à la zone sélectionnée comprennent un ou plusieurs repères visuels, images et autres informations pour noter l'utilisateur (1202, 1204) dans la réalisation d'une opération.
